# EUROPEAN PATENT SPECIFICATION

(11) **EP 3 684 155 B1**
(45) Date of publication and mention of the grant of the patent: **03.04.2024**
(21) Application number: 18856761.4
(22) Date of filing: 11.09.2018
(51) Int. Cl.: H05K 9/00, B32B 7/02, B32B 27/00

(54) **ELECTROMAGNETIC-WAVE ABSORBING SHEET**
FOLIE ZUM ABSORBIEREN ELEKTROMAGNETISCHER WELLEN
FEUILLE ABSORBANT LES ONDES ÉLECTROMAGNÉTIQUES

(30) Priority: 13.09.2017 JP 2017176000
(43) Date of publication of application: 22.07.2020
(73) Proprietor: Maxell, Ltd., Kyoto 618-8525 (JP)
(72) Inventor: TOYODA Masayuki, Kyoto 618-8525 (JP)
(74) Representative: Diehl & Partner
(86) International application number: PCT/JP2018/033662
(87) International publication number: WO 2019/054378

(56) References cited:
- EP-A1- 3 541 160
- EP-A1- 3 595 422
- JP-A- H08 307 088
- JP-A- H08 307 088
- JP-A- 2000 059 066
- JP-A- 2011 152 667
- JP-A- 2015 173 010
- JP-A- 2017 112 373
- JP-A- 2017 163 141

## Description

### Technical Field

The present disclosure relates to a flexible electromagnetic-wave absorbing sheet, and in particular to an electromagnetic-wave absorbing sheet that can absorb electromagnetic waves in or above a so-called millimeter-wave band from several tens of gigahertz (GHz) to several hundreds of gigahertz (GHz).

### Background Art

Electromagnetic-wave absorbing sheets that absorb electromagnetic waves have been used to avoid the influence of leaked electromagnetic waves emitted to the outside from an electrical circuit or the like, and the influence of electromagnetic waves reflected in an undesired manner.

In recent years, research has also advanced regarding technology that uses, as electromagnetic waves in a high frequency band exceeding the millimeter-wave band, centimeter waves having a frequency band of several gigahertz (GHz), a millimeter-wave band having a frequency of 30 gigahertz to 300 gigahertz, and electromagnetic waves having a frequency of 1 terahertz (THz), in mobile communication such as mobile telephones, wireless LANs, electronic toll collection systems (ETC), and the like.

In response to the technological trend of using such electromagnetic waves with higher frequencies, it is conceivable that demand will increase for an electromagnetic-wave absorbing sheet, which is an electromagnetic-wave absorber that absorbs unnecessary electromagnetic waves or a sheet-shaped electromagnetic-wave absorber according to which user convenience is improved due to being flexible, the electromagnetic-wave absorbing sheet being able to absorb electromagnetic waves in or above the millimeter-wave band.

A so-called electromagnetic-wave interference type (X/4) electromagnetic-wave absorbing sheet is known as this type of electromagnetic sheet. In the electromagnetic-wave interference type (X/4) electromagnetic-wave absorbing sheet, an electric resistance film is formed on one surface of a dielectric layer and an electromagnetic-wave shielding layer that reflects electromagnetic waves is formed on the other surface of the dielectric layer, and the phase of a reflected wave is shifted by half a wavelength with respect to an incident wave, whereby the incident wave on the electromagnetic-wave absorbing sheet and the reflected wave cancel each other out, and the electromagnetic wave is absorbed. The electromagnetic-wave interference type electromagnetic-wave absorbing sheet is lighter in weight and is more easily manufactured compared to an electromagnetic-wave absorbing sheet that magnetically absorbs electromagnetic waves using magnetic particles having a large specific gravity, and therefore is advantageous in that it is possible to reduce cost.

Conventionally, a so-called electromagnetic-wave interference type electromagnetic-wave absorbing sheet (electromagnetic-wave absorber) has been known in which a metal oxide such as indium tin oxide (ITO), indium oxide, tin oxide, or zinc oxide, a metal nitride, or a combination thereof is formed through ion plating, vapor deposition, sputtering, or the like as an electric resistance film formed on a surface of a dielectric layer (see Patent Document 1 and Patent Document 2).

Also, as an electromagnetic-wave interference type electromagnetic-wave absorber, a flame-resistant and light-transmissive electromagnetic-wave absorber has been proposed which includes an electric resistance layer made of a transparent conductor such as indium tin oxide film (ITO), a transparent dielectric layer made of glass or acrylic resin, and a reflective film made of a metal such as silver, gold, copper, aluminum, or the like, which is formed on the dielectric layer (see Patent Document 3).

Note that in an electromagnetic-wave interference type electromagnetic-wave absorbing sheet, in order to obtain favorable electromagnetic-wave absorbing properties, it is important to perform impedance matching for matching the input impedance of the dielectric layer with the impedance in the air (in a vacuum), but since the resistance of the electric resistance layer differs depending on the thickness of the electric resistance layer, it is necessary to strictly control the thickness in order to perform accurate impedance matching. Also, the effective thickness of the electric resistance layer changes depending on the angle of the electromagnetic waves incident on the electromagnetic-wave absorbing sheet. In order to solve these problems and obtain favorable absorption properties for electromagnetic waves of a target frequency without being influenced by the precision of the thickness of the dielectric layer and the incidence angle of the electromagnetic waves, it has been proposed that the dielectric layer is given a configuration in which two dielectric layers with different permittivities are stacked, and dome-shaped recesses and protrusions are provided on the boundary surface between the two dielectric layers (see Patent Document 4).

A wave absorber with a resistive film, a spacer and a reflective film is also proposed (see Patent Document 5).

### Citation List

### Patent Documents

Patent Document 1: JP H06-120689A
Patent Document 2: JP H09-232787A
Patent Document 3: JP 2006-086446A
Patent Document 4: JP 2008-135485A
Patent Document 5:JP H08-307088A

### Disclosure of Invention

### Problem to be Solved by the Invention

With an electromagnetic-wave interference type electromagnetic-wave absorbing sheet, the thickness of the dielectric layer decreases as the electromagnetic waves being absorbed increase in frequency, and therefore flexibility increases. An electromagnetic-wave absorbing sheet that is thinner and can be easily curved can be adhered to a greater variety of locations and has improved convenience for the user, and thus has more opportunities to be bent strongly by the user. This kind of electromagnetic-wave absorbing sheet is problematic in that cracks are likely to appear due to the electric resistance film formed by a metal oxide film or the like formed through sputtering or the like being strongly bent, and when cracks appear in the electric resistance film, the surface electric resistance of the electric resistance film increases, impedance matching deteriorates, and the electromagnetic-wave absorbing properties decrease.
Also, giving the dielectric layer a two-layer configuration and giving the surface of the dielectric layer recesses and protrusions in order to reduce the influence of the incidence angle of the electromagnetic waves incident on the electromagnetic-wave absorbing sheet leads to an increase in the cost of the electromagnetic-wave absorbing sheet.

The present disclosure solves the above-described problems and aims to realize a low-cost electromagnetic-wave absorbing sheet that is a so-called electromagnetic-wave interference type electromagnetic-wave absorbing sheet, and can favorably absorb not only electromagnetic waves in a desired frequency band that are incident in a direction perpendicular to the sheet surface, but also electromagnetic waves that are incident in a wide incidence angle range.

### Means for Solving Problem

In order to solve the above problem, an electromagnetic-wave absorbing sheet according to claim 1 is disclosed in the present application .

### Effects of the Invention

In the electromagnetic-wave absorbing sheet disclosed in the present application, an electric resistance film is formed using a conductive organic polymer, and therefore even if the sheet is strongly bent, no cracks or the like appear in the electric resistance film, the impedance matching can be maintained, and high electromagnetic-wave absorbing properties can continue to be maintained. Also, due to the surface electric resistance of the electric resistance film being set to a predetermined range, it is possible to exhibit high electromagnetic-wave absorbing properties of 20 dB or more with respect to electromagnetic waves incident on the sheet surface in a wide incidence angle range.

### Brief Description of Drawings

[FIG. 1] FIG. 1 is a cross-sectional view for illustrating a configuration of an electromagnetic-wave absorbing sheet according to the present embodiment.
[FIG. 2] FIG. 2 is a cross-sectional view for illustrating a state in which electromagnetic waves are incident on the electromagnetic-wave absorbing sheet according to the present embodiment at an incidence angle α.
[FIG. 3] FIG. 3 is a diagram showing electromagnetic-wave absorbing properties of electromagnetic-wave absorbing sheets having electric resistance films with different surface electric resistances.
[FIG. 4] FIG. 4 is a diagram showing a relationship between the incidence angle range in which a reflection attenuation amount can be set to 20 dB or more and the surface electric resistance of the electric resistance film.

### Description of the Invention

The electromagnetic-wave absorbing sheet disclosed in the present application is formed by stacking an electric resistance film, a dielectric layer, and an electromagnetic-wave shielding layer. The electric resistance film is formed using a conductive organic polymer, and the electric resistance film has a surface electric resistance of 303 Ω/sq or more and 350 Ω/sq or less, or 415 Ω/sq or more and 502 Ω/sq or less.

By doing so, the electromagnetic-wave absorbing sheet disclosed in the present application can be used as an electromagnetic-wave interference type electromagnetic-wave absorbing sheet formed by stacking the electric resistance film, the dielectric layer, and the electromagnetic-wave shielding layer, and even if the electromagnetic-wave absorbing sheet is strongly curved, cracks and the like are not likely to appear in the electric resistance film, impedance matching can be maintained, and high electromagnetic-wave absorbing properties can be exhibited. Also, due to the surface electric resistance of the electric resistance film being set to a predetermined range, the configuration of the electromagnetic-wave absorbing sheet can be prevented from becoming complicated, and it is possible to realize, at a low cost, an electromagnetic-wave absorbing sheet that exhibits high electromagnetic-wave absorbing properties with a reflection attenuation amount of 20 dB or more, in an incidence angle range of up to 40 degrees.

Furthermore, it is preferable that the electric resistance film has a surface electric resistance of 310 Ω/sq or more and 345 Ω/sq or less, or 420 Ω/sq or more and 500 Ω/sq or less. By further restricting the surface electric resistance of the electric resistance film, it is possible to achieve an electromagnetic-wave absorbing sheet that realizes high electromagnetic-wave absorbing properties with a reflection attenuation amount of 20 dB or more, with an incidence angle range of up to 50 degrees.

Also, it is preferable that the electric resistance film, the dielectric layer, and the electromagnetic-wave shielding layer are all light-transmissive, and the sheet is light-transmissive overall. By doing so, it is possible to expect a new development in use, specifically, blocking unneeded electromagnetic waves while taking in light from the outside by using the electromagnetic-wave absorbing sheet like a curtain, taking advantage of the light transmittance of the electromagnetic-wave absorbing sheet.

For example, by inserting a device that measures the intensity of the electromagnetic waves and a device that generates noise into the light-transmissive case to which the light-transmissive electromagnetic-wave absorbing sheet is adhered, it is possible to enable observation from the outside.

In the electromagnetic-wave absorbing sheet disclosed in the present application, it is preferable that the electric resistance film contains poly(3,4-ethylenedioxythiophene) (PEDOT), polystyrene sulfonic acid (PSS), and polyvinylidene fluoride (PVDF). By doing so, a surface film including a desired surface electric resistance can easily be obtained.

In this case, it is preferable that the electric resistance film further contains water-soluble polyester. By doing so, it is possible to achieve a highly-reliable electromagnetic-wave absorbing sheet having an electric resistance film with increased weather resistance and a stable surface electric resistance.

Furthermore, in the electromagnetic-wave absorbing sheet disclosed in the present application, it is preferable that the dielectric layer is set to a layer thickness at which it is possible to absorb electromagnetic waves in a high-frequency band in or above a millimeter-wave band. By doing so, it is possible to realize an electromagnetic-wave absorbing sheet that is highly flexible, has a large absorbable electromagnetic wave incidence angle, and can absorb electromagnetic waves in or above the millimeter-wave band.

Hereinafter, an electromagnetic-wave absorbing sheet disclosed in the present application will be described with reference to the drawings.

### Embodiment

First, the overall configuration of the electromagnetic-wave absorbing sheet according to the present embodiment will be described. Note that hereinafter, an electromagnetic-wave absorbing sheet that is light-transmissive overall due to the electric resistance film, the dielectric layer, and the electromagnetic-wave shielding layer included in the electromagnetic-wave absorbing sheet all being formed by light-transmissive members will be described as an example. With the electromagnetic-wave absorbing sheet described in the present embodiment, references for the light transmittance are a total light transmittance of 30% or more, and a haze value of 40 or less.

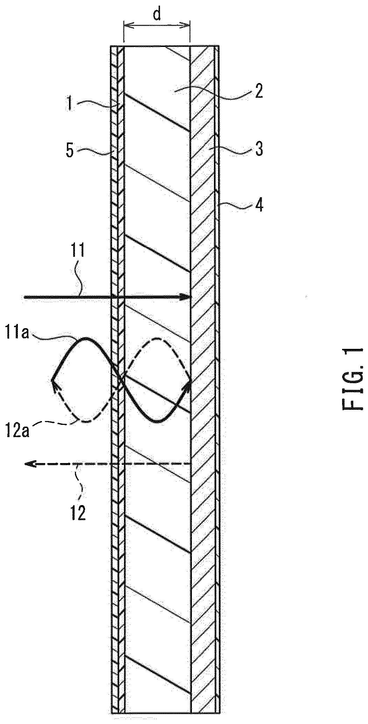

FIG. 1 is a cross-sectional diagram illustrating a configuration of the electromagnetic-wave absorbing sheet according to the present embodiment.

Note that FIG. 1 is a diagram created in order to make it easier to understand the configuration of the electromagnetic-wave absorbing sheet according to the present embodiment, and the sizes and thicknesses of the members shown in the drawing are not based on reality.

The electromagnetic-wave absorbing sheet illustrated in the present embodiment is formed by stacking an electric resistance film 1, a dielectric layer 2, and an electromagnetic-wave shielding layer 3. Note that in the electromagnetic-wave absorbing sheet shown in FIG. 1, an adhesive layer 4 is stacked on the rear surface of the electromagnetic-wave shielding layer 3, that is, the surface of the electromagnetic-wave shielding layer 3 on the side opposite to the side on which the dielectric layer 2 is disposed. Also, a protective layer 5 is stacked on the front surface of the electric resistance film 1, that is, the surface of the electric resistance film 1 on the side opposite to the side on which the dielectric layer 2 is disposed.

In the electromagnetic-wave absorbing sheet according to the present embodiment, electromagnetic waves 11 incident on the dielectric layer 2 are reflected at the interface between the electromagnetic-wave shielding layer 3 disposed on the rear surface side of the dielectric layer 2, and the dielectric layer 2, and are once again emitted to the outside as reflected waves 12. At this time, due to the thickness d of the dielectric layer 2 being set to 1/4 of the wavelength of the incident electromagnetic waves, a phase 11a of the incident waves 11 and a phase 12a of the reflected waves 12 cancel each other out, and the electromagnetic waves incident on the electromagnetic-wave absorbing sheet are absorbed.

Note that if air (permittivity ε=1) is used as the dielectric layer 2, d=X/4 is satisfied, and if the permittivity of the dielectric used in the dielectric layer 2 is εᵣ, d=1/4(εᵣ)^{-1/2} is satisfied, and the thickness d of the dielectric layer 2 can be made thinner by (εᵣ)^{-1/2}. By making the dielectric layer 2 thinner, it is possible to realize a reduction in the overall thickness of the electromagnetic-wave absorbing sheet, and it is possible to realize an electromagnetic-wave absorbing sheet with more flexibility.

The electromagnetic-wave shielding layer 3 formed by stacking on the rear surface side of the dielectric layer 2 is a layer that reflects incident electromagnetic waves at the surface on the dielectric layer 2 side, which is the interface with the dielectric layer 2.

Based on the principle of electromagnetic-wave absorption in the electromagnetic-wave interference type electromagnetic-wave absorbing sheet according to the present embodiment, the electromagnetic-wave shielding layer 3 needs to function as a reflection layer that reflects electromagnetic waves. Also, the electromagnetic-wave shielding layer needs to be flexible and light-transmissive. A conductive mesh constituted by conductive fibers, or a conductive lattice constituted by conductive wires such as ultrafine metal wires can be used as the electromagnetic-wave shielding layer 3 that can meet this kind of requirement.

The electric resistance film 1 is formed on the front surface side of the dielectric layer 2, that is, on the side of the dielectric layer 2 on which the electromagnetic waves to be absorbed are incident, which is the side opposite to the side of the dielectric layer 2 on which the electromagnetic-wave shielding layer 3 is stacked, and the electric resistance film 1 performs impedance matching between the electromagnetic-wave absorbing sheet and the air.

It is important to prevent the electromagnetic-wave absorbing properties from decreasing due to the occurrence of reflection and scattering of the electromagnetic waves when the electromagnetic waves are incident on the electromagnetic-wave absorbing sheet by preventing the input impedance of the electromagnetic-wave absorbing sheet from differing from 377 Ω/sq, which is the impedance in the air (actually, the impedance in a vacuum), when the electromagnetic waves that have transmitted through the air are incident on the electromagnetic-wave absorbing sheet. In the electromagnetic-wave absorbing sheet of the present embodiment, by forming the electric resistance film 1 as a film of a conductive organic polymer, it is possible to ensure the flexibility of the electromagnetic-wave absorbing sheet, and it is possible to maintain favorable impedance matching without cracks or the like appearing in the electric resistance film 1 and without the outer surface electric resistance changing even if the electromagnetic-wave absorbing sheet is strongly bent.

The adhesive layer 4 is a layer that is formed on the rear surface of the electromagnetic-wave shielding layer 3 such that the electromagnetic-wave absorbing sheet can be easily adhered to a predetermined location. The adhesive layer 4 can be easily formed by applying an adhesive resin paste.

Note that the adhesive layer 4 is not an essential member in the electromagnetic-wave absorbing sheet according to the present embodiment. When the electromagnetic-wave absorbing sheet is disposed at a predetermined location, a member for adhesion may be disposed on the member to which the electromagnetic-wave absorbing sheet is adhered, and when the electromagnetic-wave absorbing sheet is disposed at a predetermined location, an adhesion method such as supplying the adhesive between the electromagnetic-wave absorbing sheet and the disposing location, or using double-sided tape can be employed.

The protective layer 5 is a member that is formed on the surface of the electric resistance film 1, that is, the outermost surface on the side of the electromagnetic-wave absorbing sheet on which the electromagnetic waves are incident, and is a member that protects the electric resistance film 1.

The surface electric resistance of the conductive organic polymer forming the electric resistance film 1 of the electromagnetic-wave absorbing sheet of the present embodiment changes in some cases when moisture attaches to its surface. Also, since the electric resistance film 1 is a film made of resin, there is a risk that it will be damaged if a sharp member comes into contact with its surface, or if it is rubbed with a hard material. For this reason, it is preferable that the electric resistance film 1 is protected by covering the surface of the electric resistance film 1 with the protective layer 5.

Note that the protective layer 5 is not an essential constituent element in the electromagnetic-wave absorbing sheet according to the present embodiment, and it is possible to select a configuration of the electromagnetic-wave absorbing sheet that does not include the protective layer 5 if there is little concern that the surface electric resistance will change accompanying the attachment of moisture to the surface, or that the surface of the electric resistance film 1 will be damaged, depending on the material of the conductive organic polymer.

Also, as will be described later, a resin material such as polyethylene terephthalate can be used as the protective layer 5. The resin material used as the protective layer 5 has a certain resistance, but by setting the film thickness of the protective layer 5 to be thin, the influence that the presence of the protective layer 5 has on the surface electric resistance of the electromagnetic-wave absorbing sheet can be set to a level that is not problematic in practical applications.

Next, the members constituting the electromagnetic-wave absorbing sheet according to the present embodiment will be described in detail.

### Electric Resistance Film

In the electromagnetic-wave absorbing sheet according to the present embodiment, the electric resistance film 1 is constituted by a conductive organic polymer.

It is preferable that a conjugate conductive organic polymer is used as the conductive organic polymer, and it is preferable to use polythiophene or a derivative thereof, or polypyrrole or a derivative thereof as the conductive organic polymer.

Specific examples of a polythiophene-based conductive polymer that is suitable to be used in the electric resistance film 1 of the electromagnetic-wave absorbing sheet according to the present embodiment include poly(thiophene), poly(3-methylthiophene), poly(3-ethylthiophene), poly(3-propylthiophene), poly(3-butylthiophene), poly(3-hexylthiophene), poly(3-heptylthiophene), poly(3-octylthiophene), poly(3-decylthiophene), poly(3-dodecylthiophene), poly(3-octadecylthiophene), poly(3-bromothiophene), poly(3-chlorothiophene), poly(3-iodothiophene), poly(3-cyanothiophene), poly(3-phenylthiophene), poly(3,4-dimethylthiophene), poly(3,4-dibutylthiophene), poly(3-hydroxythiophene), poly(3-methoxythiophene), poly(3-ethoxythiophene), poly(3-butoxythiophene), poly(3-hexyloxythiophene), poly(3-heptyloxythiophene), poly(3-octyloxythiophene), poly(3-decyloxythiophene), poly(3-dodecyloxythiophene), poly(3-octadecyloxythiophene), poly(3,4-dihydroxythiophene), poly(3,4-dimethoxythiophene), poly(3,4-diethoxythiophene), poly(3,4-dipropoxythiophene), poly(3,4-dibutoxythiophene), poly(3,4-dihexyloxythiophene), poly(3,4-diheptyloxythiophene), poly(3,4-dioctyloxythiophene), poly(3,4-didecyloxythiophene), poly(3,4-didodecyloxythiophene), poly(3,4-ethylenedioxythiophene), poly(3,4-propylenedioxythiophene), poly(3,4-butenedioxythiopene), poly(3-methyl-4-methoxythiophene), poly(3-methyl-4-ethoxythiophene), poly(3-carboxythiophene), poly(3-methyl-4-carboxythiophene), poly(3-methyl-4-carboxyethylthiophene), and poly(3-methyl-4-carboxybutylthiophene).

Also, specific examples of a polypyrrole-based conductive polymer that is suitable to be used in the electric resistance film 1 include polypyrrole, poly(N-methylpyrrole), poly(3-methylpyrrole), poly(3-ethylpyrrole), poly(3-n-propylpyrrole), poly(3-butylpyrrole), poly(3-octylpyrrole), poly(3-decylpyrrole), poly(3-dodecylpyrrole), poly(3,4-dimethylpyrrole), poly(3,4-dibutylpyrrole), poly(3-carboxypyrrole), poly(3-methyl-4-carboxypyrrole), poly(3-methyl-4-carboxyethylpyrrole), poly(3-metyl-4-carboxybutylpyrrole), poly(3-hydroxypyrrole), poly(3-methoxypyrrole), poly(3-ethoxypyrrole), poly(3-butoxypyrrole), poly(3-hexyloxypyrrole), poly(3-methyl-4-hexyloxypyrrole), and poly(3-methyl-4-hexyloxypyrrole).

In addition, an organic polymer in which the main chain is constituted by a π-conjugated system can be used as the electric resistance film 1, and a polyacene-based conductive polymer, a polyphenylene-based conductive polymer, a polyphenylene vinylene-based conductive polymer, a polyaniline-based conductive polymer, a polyacetylene-based conductive polymer, a polythiophene vinylene-based conductive polymer, copolymers thereof, and the like can be used as the electric resistance film 1.

Note that polyanions can be used as counter anions in the conductive organic polymer used in the electric resistance film. Although there is no particular limitation on the polyanions, it is preferable that an anion group that can cause chemical oxidation doping to occur is included in the conjugate conductive organic polymer used in the above-described electric resistance film. Examples of this kind of anion group include groups represented by the general formulas -O-SOsX, -O-PO(OX)₂, -COOX, -SO₃X, and the like (in the formulas, X indicates a hydrogen atom or an alkali metal atom), and among these, the groups indicated by -SO₃X and -O-SO₃X are particularly preferable since they have an excellent dope effect on conjugate conductive organic polymers.

The above-described conductive organic polymers may be used alone, or in combination of two or more. Among the materials described as examples above, a polymer composed of one or two types selected from polypyrrole, poly(3-methoxythiophene), poly(3,4-ethylenedioxythiophene), poly(2 -anilinesulfonic acid), and poly(3 - anilinesulfonic acid) is preferable since they have higher light transmittance and conductivity.

In particular, poly(3,4-ethylenedioxythiophene: PEDOT) and polystyrene sulfonic acid (PSS) can be used as the combination of the conjugated conductive organic polymer and the polyanion.

Also, in the electric resistance film 1 according to the present embodiment, a dopant can be used in combination to match the input impedance of the electromagnetic-wave absorbing sheet with the impedance in the air by controlling the electric conductivity of the conductive organic polymer. Halogens such as iodine and chlorine, Lewis acids such as BF₃ and PF₅, proton acids such as nitric acid and sulfuric acid, transition metals, alkali metals, amino acids, nucleic acids, surfactants, pigments, chloranil, tetracyanoethylene, TCNQ, and the like can be used as the dopant. More specifically, it is preferable that the surface electric resistance of the electric resistance film 1 is set to a value that is about a few percent greater than or less than 377 Ω/sq, and at this time, the blending ratio of the conductive organic polymer and the dopant can be set to, for example, conductive organic polymer : dopant = 12 to 14 in terms of mass ratio.

Furthermore, a material that also contains polyvinylidene fluoride and water-soluble polyester is preferable as the material constituting the electric resistance film 1. As a result of the material containing these compounds, the weather resistance of the electric resistance film 1 improves, and therefore change over time in the surface electric resistance of the electric resistance film 1 can be suppressed, and it is possible to realize a highly-reliable electromagnetic-wave absorbing sheet that can maintain stable electromagnetic-wave absorbing properties.

Polyvinylidene fluoride can fulfill the function of a binder in the conductive organic polymer, improve film formation, and increase areal contact with the base due to being added to the composition when coating the conductive organic polymer.

Also, since water-soluble polyester has a high compatibility with the conductive polymer, the conductive polymer can be immobilized in the electric resistance film 1 by adding the water-soluble polyester to the coating composition of the conductive organic polymer constituting the electric resistance film 1, and it is possible to form a more homogeneous film. As a result, by using the water-soluble polyester, there is little change in the surface electric resistance, even in a more severe high-temperature high-humidity environment, and it is possible to maintain the state in which impedance matching with the impedance in the air is achieved.

The content of the conductive organic polymer in the electric resistance film 1 is preferably 10 mass% or more and 35 mass% or less with respect to the total mass of the solid content included in the composition of the electric resistance film 1. If the content falls below 10 mass%, the conductivity of the electric resistance film 1 tends to decrease. For this reason, as a result of the surface electric resistance of the electric resistance film 1 being set to a predetermined range in order to achieve impedance matching, the electromagnetic-wave absorbing sheet tends to become thicker overall and the optical properties tend to deteriorate due to the film thickness of the electric resistance film 1 increasing. On the other hand, if the content exceeds 35 mass%, the coating suitability at the time of coating the electric resistance film 1 decreases due to the structure of the conductive organic polymer, and it tends to be difficult to form a favorable electric resistance film 1, haze of the electric resistance film 1 tends to increase, and the optical properties tend to deteriorate.

Note that the electric resistance film 1 can be formed by coating the base with a coating composition serving as a coating material for forming the electric resistance film and drying the resulting composition as described above.

A coating method such as bar-coating, reverse coating, gravure coating, micro-gravure coating, die-coating, dipping, spin-coating, slit-coating, and spray-coating can be used as the method for coating the base with the coating material for forming the electric resistance film. The drying performed after the coating is preferably performed for 5 to 60 minutes at 100 to 150°C, as long as the solvent component of the coating material for forming the electric resistance film evaporates. If the solvent remains in the electric resistance film 1, the strength tends to deteriorate. For example, hot air drying, heating drying, vacuum drying, natural drying, or the like can be performed as the drying method. Also, the electric resistance film 1 may be formed by emitting UV light (ultraviolet rays) or an EB (electron beam) to the coating film to cure the coating film.

Note that although the base used to form the electric resistance film 1 is not particularly limited, a transparent base that has transparency is preferable thereas. Various materials such as resin, rubber, glass, and a ceramic material can be used as the material of the transparent base.

In the electromagnetic-wave absorbing sheet according to the present embodiment, as a result of the electric resistance film 1 with a surface electric resistance of 377 Ω/sq being formed using the above-described conductive organic polymer, it is possible to match the impedance of the electromagnetic waves incident on the electromagnetic-wave absorbing sheet with the impedance in the air, and more favorable electromagnetic-wave absorbing properties can be obtained by reducing reflection and scattering of the electromagnetic waves at the surface of the electromagnetic-wave absorbing sheet.

### Dielectric Layer

The dielectric layer 2 of the electromagnetic-wave absorbing sheet according to a non-claimed example be formed using a dielectric such as polyvinylidene fluoride, polyester resin, glass, transparent silicone rubber, transparent fluororesin film, or OCR (optically clear resin). The dielectric layer 2 of the electromagnetic-wave absorbing sheet according to the present embodiment is formed using a dielectric of OCA (optically clear adhesive) . Note that the dielectric layer 2 can be formed as a one-layer configuration using one type of material, or can have a configuration in which two or more layers of the same type or different types of material are stacked. Coating, press-molding, extrusion molding, or the like can be used to form the dielectric layer 2.

As described above, the electromagnetic-wave absorbing sheet according to the present embodiment is an electromagnetic-wave interference type (X/4) electromagnetic-wave absorbing sheet in which the phase of the electromagnetic waves incident on the electromagnetic-wave absorbing sheet and the phase of the reflected waves reflected by the electromagnetic-wave shielding layer are shifted by 1/2 the wavelength, whereby the incident waves and the reflected waves cancel each other out, and the electromagnetic waves are absorbed. For this reason, the thickness (d in FIG. 1) of the dielectric layer is set corresponding to the wavelength to the electromagnetic waves to be absorbed.

Note that regarding the value of d, if there is a gap between the electric resistance film 1 and the electromagnetic-wave shielding layer 3, that is, if the dielectric layer 2 is made of air, d=λ/4 holds true, but if the dielectric layer 2 is made of a material with a permittivity εr, d=λ/4(εr)^{-1/2} holds true, and therefore the value of the thickness d of the dielectric layer 2 can be made smaller by (εr)^{-1/2} and the overall thickness of the electromagnetic-wave absorbing sheet can be reduced by using a material with a large permittivity as the material constituting the dielectric layer 2. Since the electromagnetic-wave absorbing sheet according to the present embodiment is flexible, the thinner the dielectric layer 2 included in the electromagnetic-wave absorbing sheet or the electromagnetic-wave absorbing sheet itself is, the easier the electromagnetic-wave absorbing sheet will be to curve, which is more preferable. Also, considering that the electromagnetic-wave absorbing sheet according to the present embodiment is often used adhered via a later-described adhesive layer 4 or the like to a member in which it is desirable to avoid electromagnetic wave leakage, it is preferable that the electromagnetic-wave absorbing sheet is thin and easily conforms to the shape of the adhered portion, and that the weight of the sheet is further reduced.

Note that compared to the case where the electric resistance film 1 is arranged at a position that is λ/4 away from the electromagnetic-wave shielding layer 3, if the dielectric layer 2 having the transmittance εr is used between the electromagnetic-wave shielding layer 3 and the electric resistance film 1, the thickness d can be set to d=λ/4(εr)^{-1/2}, and the thickness of the dielectric layer 2 can be reduced. In this manner, by adjusting the value of the permittivity εr and the thickness of the dielectric layer 2, it is possible to control the wavelength of the electromagnetic waves to be absorbed by the electromagnetic-wave absorbing sheet including the dielectric layer 2.

### Electromagnetic-Wave Shielding Layer

The electromagnetic-wave shielding layer 3 of the electromagnetic-wave absorbing sheet according to the present embodiment is a member that is arranged on the side opposite to the electromagnetic-wave absorbing sheet via the dielectric layer 2, and that reflects the electromagnetic waves that are incident from the resistance film 1.

At the same time, the electromagnetic-wave shielding layer 3 needs to have at least flexibility for conforming and curving when the electric resistance film 1 and the dielectric layer 2 curve, and light transmittance.

A conductive mesh constituted by conductive fibers can be employed as an electromagnetic-wave shielding layer 3 that can meet this requirement. For example, the conductive mesh can be formed by attaching metal to a mesh knit using polyester monofilaments and thus making the mesh conductive. Copper, silver, or the like, which is highly conductive, can be used as the metal. A conductive mesh in which a black reflection preventing layer is added to the outer side of metal film in order to reduce reflection by the metal film covering the surface of the mesh is also commercially available.

Also, a conductive lattice in which metal wires such as thin copper wires with a diameter of several tens to several hundreds of pm are arranged horizontally and vertically can be used as the electromagnetic-wave shielding layer 3.

Note that the electromagnetic-wave shielding layer 3 formed using the above-described mesh or conductive lattice is configured to have the minimal thickness at which it is possible to realize the surface electric resistance required for the electromagnetic-wave shielding layer in order to ensure flexibility and light transmittance. Also, if the fibers of the conductive mesh or the wires of the conductive lattice are damaged or cut, it is difficult to realize the desired surface electric resistance. For this reason, a reinforcement layer and protective layer formed using resin that is light-transmissive can be further formed on the rear surface side of the conductive lattice, and the electromagnetic-wave shielding layer 3 formed using a stacked body in which the electromagnetic-wave reflecting portion formed by the conductive material and a film forming portion made of resin are stacked can be used.

### Adhesive Layer

In the electromagnetic-wave absorbing sheet according to the present embodiment, by providing the adhesive layer 4, the electromagnetic-wave absorbing sheet, which is a stacked body obtained by stacking the electric resistance film 1, the dielectric layer 2, and the electromagnetic-wave shielding layer 3, can be adhered at a desired position, such as the inner surface of the housing storing the electrical circuit, or the inner surface or outer surface of an electrical device. In particular, since the electromagnetic-wave absorbing sheet of the present embodiment is flexible, the electromagnetic-wave absorbing sheet can be easily adhered to a curved surface, and by providing the adhesive layer 4 on the rear surface, the ease of handling the electromagnetic-wave absorbing sheet improves.

A known material used as an adhesive layer, such as adhesive tape, an acrylic-based adhesive, a rubber-based adhesive, a silicone-based adhesive, or the like can be used as the adhesive layer 4. A tackifier or a cross-linking agent can also be used to adjust the tackiness to the adherend, and to reduce adhesive residue. The tackiness to the adherend is preferably 5 N/10 mm to 12 N/10 mm. If the tackiness is smaller than 5 N/10 mm, the electromagnetic-wave absorbing sheet will easily peel off of the adherend or shift in some cases. Also, if the tackiness is greater than 12 N/10 mm, the electromagnetic-wave absorbing sheet will be more difficult to peel off of the adherend.

The thickness of the adhesive layer 4 is preferably 20 pm to 100 pm. If the thickness of the adhesive layer 4 is less than 20 µm, the tackiness will decrease, and the electromagnetic-wave absorbing sheet will easily peel off of the adherend or shift in some cases. If the thickness of the adhesive layer 4 is greater than 100 um, the electromagnetic-wave absorbing sheet will be unlikely to peel off of the adherend. If the cohesive force of the adhesive layer is small, adhesive residue will appear on the adherend in some cases when the electromagnetic-wave absorbing sheet is peeled off. Also, a small cohesive force is a factor contributing to a decreasing in the overall flexibility of the electromagnetic-wave absorbing sheet.

Note that an adhesive layer 4 that adheres the electromagnetic-wave absorbing sheet to the adherend such that it cannot be peeled off can be used as the adhesive layer 4 used in the electromagnetic-wave absorbing sheet according to the present embodiment, and an adhesive layer 4 that performs peelable adhesion can also be used thereas. Also, as described before, in the electromagnetic-wave absorbing sheet according to the present embodiment, the configuration including the adhesive layer 4 is not an essential element, but the electromagnetic-wave absorbing sheet can be adhered to a desired member using various types of conventionally common adhesion methods.

### Protective Layer

With the electromagnetic-wave absorbing sheet according to the present embodiment, the protective layer 5 can be provided on the incident surface of the electromagnetic waves, which is the surface of the electric resistance film 1.

In the electromagnetic-wave absorbing sheet according to the present embodiment, the surface electric resistance of the conductive organic polymer used as the electric resistance film 1 changes in some cases under the influence of the humidity in the air. For this reason, by providing the protective layer 5 on the surface of the electric resistance film 1, the influence of the humidity can be reduced, and it is possible to effectively inhibit deterioration of the electromagnetic-wave absorbing properties achieved through impedance matching.

For example, polyethylene terephthalate with a thickness of 25 pm can be used as the protective layer 5 in the electromagnetic-wave absorbing sheet of the present embodiment, and this can be formed by being adhered to the surface of the electric resistance film 1 using adhesive made of a resin material.

Note that the protective layer 5 can prevent moisture from permeating the electric resistance film 1 as a result of the protective layer 5 being formed as a film that covers the entire surface of the electric resistance film 1. It is thought that the component of the surface electric resistance of the protective layer 5 formed as the film made of resin influences the component of the surface electric resistance of the stacked electric resistance film 1 as a component connected in parallel thereto. For this reason, it is thought that if the protective layer 5 is not too thick, the influence that the protective layer 5 has on the input impedance of the electromagnetic-wave absorbing sheet is very small. Also, upon considering the influence of the surface electric resistance of the protective layer 5 on the input impedance of the electromagnetic-wave absorbing sheet, the surface electric resistance of the electric resistance film 1 can be set to a numerical value that is more suitable.

The thickness of the protective layer 5 is preferably thinner within a range of being able to protect the electric resistance film 1. Specifically, the thickness of the protective layer 5 is preferably 150 pm or less, and more preferably 100 pm or less. If the thickness of the protective layer exceeds 150 pm, the electromagnetic-wave absorbing performance decreases and the electromagnetic-wave absorption amount falls below 20 dB in some cases. Also, since the overall thickness of the electromagnetic-wave absorbing sheet increases, flexibility decreases.

### Working Example

Hereinafter, the results of actually producing multiple types of sheets having electric resistance films with different surface electric resistances as the electromagnetic-wave absorbing sheet according to the present embodiment and measuring the changes in the electromagnetic-wave absorbing properties when the incidence angle of the electromagnetic waves is changed will be described.

### Weather Resistance of Electric Resistance Film

The electric resistance film was produced from an electric resistance film liquid obtained by adding and mixing together the components shown below.

| | | |
|---|---|---|
| (1) | Conductive polymer dispersion Conductive polymer manufactured by Heraeus Corporation (PEDOT-PSS) PH-100 (product name), | 36.7 parts |
| (2) | Solid content concentration: 1.2 mass% PVDF dispersion | 5.6 parts |
| | LATEX32 (product name) manufactured by Arkema Corporation | |
| | Solid content concentration: 20 mass%, solvent: water | |
| (3) | Water-soluble polyester aqueous solution | 0.6 parts |
| | PLAS COAT Z561 (product name) manufactured by Goo Chemical Co.,Ltd. | |
| | Solid content concentration: 25 mass% | |
| (4) | Organic solvent (dimethyl sulfoxide) | 9.9 parts |
| (5) | Water-soluble solvent (ethanol) | 30.0 parts |
| (6) | Water | 17.2 parts |

An electric resistance film liquid produced using the above-described composition was applied to a sheet made of polyethylene terephthalate (50 pm thick) serving as a base through bar coating such that its thickness after drying was a predetermined thickness, and the resulting composition was heated for 5 minutes at 150°C thereafter to form an electric resistance film.

Next, transparent silicone OCA with a thickness of 500 µm was adhered to the surface on the side of the base opposite to the side on which the electric resistance film was formed. As a result, a dielectric layer with a thickness of 550 pm, including the 50 µm of the base, was formed. Furthermore, an electromagnetic-wave shielding layer was formed on the silicone OCA using a conductive mesh Su-4x-13227 (product name) manufactured by Seiren Corporation, and thus the electromagnetic-wave absorbing sheet was produced. Note that the adhesive layer and the surface protection layer were not formed on the electromagnetic-wave absorbing sheet used in the current instance of measurement.

Also, the following six types of electromagnetic-wave absorbing sheets were produced with different surface electric resistances by changing the thicknesses of the electric resistance films.

| | |
|---|---|
| (Sheet 1) | Surface electric resistance: 310 Ω/sq (thickness 160 nm) |
| | Transmittance: 66.2%, haze: 12% |
| (Sheet 2) | Surface electric resistance: 345 Ω/sq (thickness 147 nm) |
| | Transmittance: 66.2%, haze: 12% |
| (Sheet 3) | Surface electric resistance: 377 Ω/sq (thickness 120 nm) |
| | Transmittance: 66.2%, haze: 12% |
| (Sheet 4) | Surface electric resistance: 420 Ω/sq (thickness 118 nm) |
| | Transmittance: 66.2%, haze: 12% |
| (Sheet 5) | Surface electric resistance: 465 Ω/sq (thickness 107 nm) |
| | Transmittance: 66.2%, haze: 12% |
| (Sheet 6) | Surface electric resistance: 500 Ω/sq (thickness 100 nm) |
| | Transmittance: 66.2%, haze: 12% |

Here, the surface electric resistance of the electric resistance film in the sheet 3 is the same as the value of the impedance in a vacuum (377 Ω), and the sheet 3 corresponds to an electromagnetic-wave absorbing sheet in which conventional impedance matching has been performed.

### Measurement of Electromagnetic-Wave Absorbing Properties

The electromagnetic-wave absorbing properties in a band of 60 to 90 GHz were measured using a free-space method, with the above-produced sheets 1 to 6 serving as the measurement targets. Specifically, the intensity ratios between the incident waves and the reflected waves obtained when electromagnetic waves were emitted to the electromagnetic-wave absorbing sheets were obtained as voltage values using a free space measurement apparatus manufactured by KEYCOM Corporation and a vector network analyzer MS4647B (product name) manufactured by Anritsu Corporation.

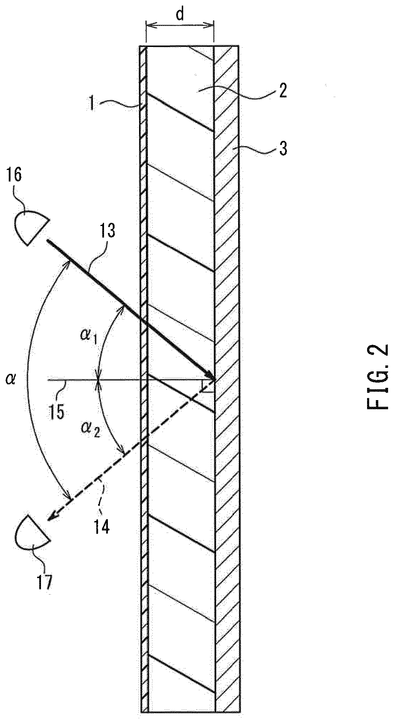

FIG. 2 shows a state in which electromagnetic waves are incident at a predetermined incidence angle α on an electromagnetic-wave absorbing sheet.

As shown in FIG. 2, incident waves 13 that have passed through the electric resistance film 1 and the dielectric layer 2 of the electromagnetic-wave absorbing sheet become reflected waves 14 by being reflected by the surface of the electromagnetic-wave shielding layer 3. At this time, in an ideal state, the angle formed by the incident waves 13 and the angle formed by the reflected waves 14 with respect to a perpendicular line 15 that is perpendicular to the surface of the electromagnetic-wave absorbing sheet are both the same angle. Note that in the present description, for the sake of convenience, the angle formed by the incident waves 13 and the reflected waves 14 shown in FIG. 2 will be called incidence angle α. The incidence angle α is the sum of an incidence angle α₁ of the incident waves 13 and a reflection angle α₂ of the reflected waves 14, which serve as terms used in the field of optics, or in other words, α=α₁+α₂ (normally, α₁=α₂).

In view of this, a transmission antenna 16 of the free space measurement apparatus was arranged in the direction of the base of the solid-line arrow 13 in FIG. 2, a reception antenna 17 was arranged in the direction of the tip of the dotted-line arrow 14 in FIG. 2, the angle α was increased from a state in which the incidence angle α was equal to 0 degrees, that is, a perpendicular incidence state, and the electromagnetic waves that were emitted from the transmission antenna 16 and reflected by the surface of the electromagnetic-wave shielding layer 3 were measured by the reception antenna 17 until the maximum incidence angle α was equal to 65 degrees, and the reflection attenuation amount was obtained in units of dB by comparing the intensities.

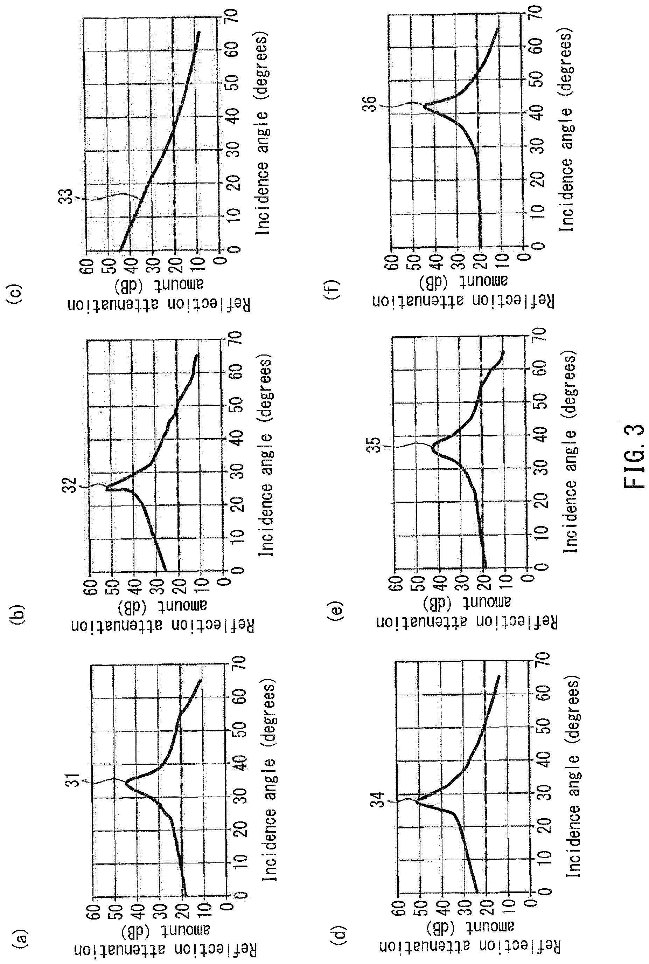

FIG. 3 is a diagram showing relationships between the incidence angles α (units: degrees) with respect to the electromagnetic-wave absorbing sheets and the reflection attenuation amounts (units: dB) in the electromagnetic-wave absorbing sheets. Note that in FIG. 3, FIG. 3(a) shows a reflection attenuation property of the sheet 1 (surface electric resistance: 310 Ω/sq), FIG. 3(b) shows a reflection attenuation property of the sheet 2 (surface electric resistance: 345 Ω/sq), FIG. 3(c) shows a reflection attenuation property of the sheet 3 (surface electric resistance: 377 Ω/sq), FIG. 3(d) shows a reflection attenuation property of the sheet 4 (surface electric resistance: 420 Ω/sq), FIG. 3(e) shows a reflection attenuation property of the sheet 5 (surface electric resistance: 465 Ω/sq), and FIG. 3(f) shows a reflection attenuation property of the sheet 6 (surface electric resistance: 500 Ω/sq).

As shown in FIG. 3(a), with the reflection attenuation property (reference numeral 31) in the case of using the sheet 1 having an electric resistance film 1 with a surface electric resistance of 310 Ω/sq, the reflection attenuation amount is approximately 18 dB in the state in which the incidence angle α is equal to 0 degrees, which is perpendicular incidence, the reflection attenuation amount increases when the incidence angle increases, the reflection attenuation amount is 20 dB when the incidence angle α is 5 degrees, and the reflection attenuation amount reaches approximately 45 dB, which is the peak, when the incidence angle α is 34 degrees. Thereafter, the reflection attenuation amount decreases as the incidence angle α increases, and the reflection attenuation amount reaches 20 dB when the incidence angle α is 55 degrees. According to this result, with the sheet 1, it is understood that even if the electromagnetic waves are incident at incidence angles having a 50-degree incidence angle range between incidence angles α of 5 degrees and 55 degrees, a high reflection attenuation amount of 20 dB or more can be maintained. Also, in the sheet 1, it is understood that the surface electric resistance of the electric resistance film 1 is subjected to impedance matching at 310 Ω/sq with respect to electromagnetic waves with an incidence angle α of 34 degrees.

With the reflection attenuation property (reference numeral 32) in the case of the sheet 2 having an electric resistance film 1 with a surface electric resistance of 345 Ω/sq, the reflection attenuation amount is approximately 27 dB in a state in which the incidence angle α is equal to 0 degrees, which is perpendicular incidence, the reflection attenuation amount reaches a peak of 52 dB when the incidence angle α is approximately 26 degrees, and the reflection attenuation amount reaches 20 dB when the incidence angle α is equal to 50 degrees. For this reason, with the sheet 2 as well, it is understood that a high reflection attenuation amount of 20 dB or more can be maintained in an incidence angle range of 50 degrees. Also, with the sheet 2, it is understood that the surface electric resistance of the electric resistance film 1 is subjected to impedance matching at 345 Ω/sq with respect to the electromagnetic waves with an incidence angle α of 26 degrees.

In the sheet 2, it is thought that the incidence angle α at which the reflection attenuation amount reaches its peak is smaller compared to that of the sheet 1 shown in FIG. 3(a) because the surface electric resistance of the sheet 2 is closer to the surface electric resistance 377 Ω/sq, which is impedance-matched in the case where the incidence angle α is equal to 0 degrees, which is perpendicular incidence.

With the reflection attenuation property (reference numeral 33) of the sheet 3 having a surface electric resistance of 377 Ω/sq shown in FIG. 3(c), the maximum reflection attenuation amount of approximately 45 dB is reached when the incidence angle α is equal to 0 degrees, which is perpendicular incidence, and the reflection attenuation amount decreases as the incidence angle α increases. Then, when the incidence angle α is around 35 degrees, the reflection attenuation amount falls below 20 dB. Thus, it is understood that if impedance matching is performed, a very high reflection attenuation amount can be obtained when the incidence angle α is 0 degrees, which is perpendicular incidence, whereas if the incidence angle α increases from 0 degrees, a favorable reflection attenuation amount can be maintained only in a relatively small incidence angle range.

Note that a reflection attenuation property in which the reflection attenuation amount obtained when the incidence angle α is 0 degrees is the greatest and the reflection attenuation amount gradually decreases as the value of the incidence angle α increases, such as that shown in FIG. 3(c), was similarly observed in the electromagnetic-wave absorbing sheets having electric resistance films 1 with surface electric resistances in the range of being 30 SZ/sq higher and lower than 377 Ω/sq. That is, the surface electric resistance of the electric resistance film 1 is impedance-matched at 377 Ω/sq with respect to the electromagnetic waves that are perpendicularly incident on the electromagnetic-wave absorbing sheet.

In the case of the electromagnetic-wave attenuation property (reference numeral 34) of the sheet 4 having a surface electric resistance of 420 Ω/sq, which is shown in FIG. 3(d), the reflection attenuation amount is approximately 25 dB when α is equal to 0 degrees, which is perpendicular incidence, and thereafter, a peak value of approximately 51 dB is reached when the incidence angle α is approximately 28 degrees, and thereafter, the reflection attenuation amount decreases, and the reflection attenuation amount reaches 20 dB when the incidence angle α is 50 degrees. In this manner, in the sheet 3, it is possible to realize a high reflection attenuation amount in a 50-degree incidence angle range. Also, based on these results, with the sheet 3, it is understood that the surface electric resistance of the electric resistance film 1 is impedance-matched at 420 Ω/sq with respect to the electromagnetic waves with an incidence angle α of 28 degrees.

With the electromagnetic-wave attenuation property (reference numeral 35) of the sheet 5 having a surface electric resistance of 465 Ω/sq shown in FIG. 3(e), the reflection attenuation amount is approximately 19 dB when the incidence angle α is equal to 0 degrees, which is perpendicular incidence, the reflection attenuation amount increases when the incidence angle increases, the reflection attenuation amount reaches 20 dB when the incidence angle α is 4 degrees, and the reflection attenuation amount reaches a peak of about 42 dB when the incidence angle α is 37.5 degrees. Thereafter, as the incidence angle α increases, the reflection attenuation amount decreases, and when the incidence angle α is 56 degrees, the reflection attenuation amount reaches 20 dB. According to this result, with the sheet 5, it is understood that even if the electromagnetic waves are incident at incidence angles having a 53-degree incidence angle range between incidence angles α of 3 degrees and 56 degrees, a high reflection attenuation amount of 20 dB or more can be maintained. Also, in the sheet 5, it is understood that the surface electric resistance of the electric resistance film 1 has been impedance-matched at 465 Ω/sq with respect to the electromagnetic waves with an incidence angle α of 37.5 degrees.

With the electromagnetic-wave attenuation property (reference numeral 36) of the sheet 6 having a surface electric resistance of 500 Ω/sq shown in FIG. 3(f), the reflection attenuation amount is approximately 19 dB when the incidence angle α is equal to 0 degrees, which is perpendicular incidence, the reflection attenuation amount increases when the incidence angle increases, the reflection attenuation amount is 20 dB when the incidence angle α is 3 degrees, the reflection attenuation amount reaches a peak value of approximately 51 dB when the incidence angle α is 43 degrees, and thereafter the reflection attenuation amount decreases and reaches 20 dB when the incidence angle α is 53 degrees. According to this result, with the sheet 6, it is possible to maintain a reflection attenuation amount of 20 dB or more with respect to electromagnetic waves in a 50-degree incidence angle range in which the incidence angle α is 3 to 53 degrees. Also, with the sheet 6, it is indicated that the surface electric resistance of the electric resistance film 1 is impedance-matched at 500 Ω/sq.

In this manner, it is understood that with the electromagnetic-wave absorbing sheets shown in FIGS. 3(a) to 3(f), which have impedance-matched surface electric resistances of 377 Ω/sq, which is generally considered preferable, based on the changes in the reflection attenuation amounts obtained when the incidence angles α are changed, the electromagnetic-wave absorbing properties rapidly deteriorate when the incidence angles α increase, whereas the surface electric resistances of the electric resistance films subjected to impedance matching differ according to the incidence angles of the electromagnetic waves.

Also, it was understood that there is a tendency to be able to favorably absorb electromagnetic waves even when the range of the incidence angles α is a large value, such as 50 degrees, by actively causing the surface electric resistances to transition within a range of being slightly different from 377 Ω/sq from the viewpoint of realizing an electromagnetic-wave absorbing sheet that can favorably absorb electromagnetic waves that are incident at incidence angles in a predetermined range, such as when it is predicted that the incidence angles of the electromagnetic waves incident on the electromagnetic-wave absorbing sheet will change.

Specifically, it was understood that there is a region in which the reflection attenuation amount can be maintained at 20 dB or more, even if the range of the incidence angles α is 40 or 50 degrees in ranges in which the surface electric resistance of the electric resistance film that reaches the input impedance in the space is less than and greater than 377 Ω/sq. Since the reflection attenuation amount being 20 dB means that 99% of the electromagnetic waves will be absorbed, it can be determined that the electromagnetic-wave absorbing properties are sufficient in practical applications.

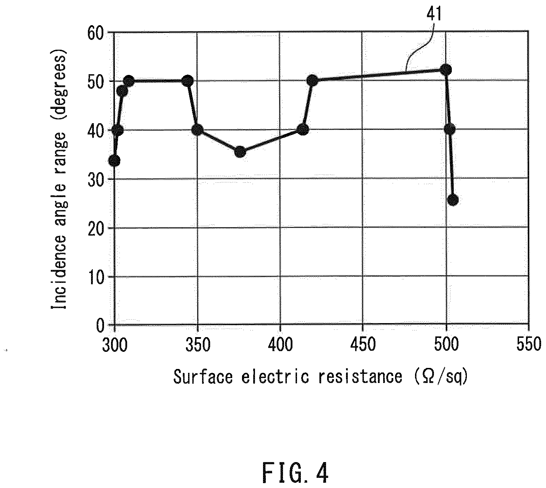

FIG. 4 is a diagram showing an incidence angle range in which the reflection attenuation amount can be maintained at 20 dB when the surface electric resistance of the electric resistance film is changed.

As indicated by reference numeral 41 in FIG. 4, in a range in which the surface electric resistance of the electric resistance film 1 is 303 Ω/sq or more and 350 Ω/sq or less, or in a range in which the surface electric resistance is 415 Ω/sq or more and 502 Ω/sq or less, it is possible to ensure a reflection attenuation amount of -20 dB in a range of incidence angles α of up to 40 degrees. Also, in a range in which the surface electric resistance of the electric resistance film 1 is 310 Ω/sq or more and 345 Ω/sq or less, or in a range in which the surface electric resistance is 420 Ω/sq or more and 500 Ω/sq or less, it is possible to ensure a reflection attenuation amount of-20 dB or more in a range of incidence angles α of up to 50 degrees.

As a result, it is possible to obtain, as the electromagnetic-wave absorbing sheet according to the present embodiment, an electromagnetic-wave absorbing sheet having electromagnetic-wave absorbing properties in which the reflection attenuation amount is 20 dB or more, which is thought to be a sufficient level for practical applications, in an incidence angle range of up to 40 degrees, by changing the surface electric resistance of the electric resistance film from 377 Ω/sq, which is the impedance in the air, to a range of 303 Ω/sq or more and 350 Ω/sq or less, or a range of 415 Ω/sq or more and 502 Ω/sq or less, even if the incidence angles of the electromagnetic waves on the electromagnetic-wave absorbing sheet vary significantly.

### Checking Flexibility and Light Transmittance

Note that the electromagnetic-wave absorbing sheet according to the present embodiment was produced using the procedure described in the working example above, was cut to a size of 5× 10 cm, and was placed with the electric resistance film facing outward on a horizontally-arranged circular tube-shaped rod (a mandrel) made of aluminum having a diameter of 6 mm, and even if 300 g of weight was attached to both ends of the sheet and maintained for 30 seconds, it was confirmed that no change occurred in the value of the surface electric resistance of the electric resistance film, and that the electromagnetic-wave absorbing sheet according to the present embodiment had high flexibility.

It was confirmed that the optical property of the electromagnetic-wave absorbing sheet according to the present embodiment was within a preferable numeric value range in which the total light transmittance was 30% or more and the haze value was 40 or less.

As described above, the electric resistance film that is arranged on the surface on the side of the electromagnetic-wave absorbing sheet according to the present embodiment on which the electromagnetic waves to be absorbed are incident is constituted by a conductive organic polymer, and thus the electromagnetic-wave absorbing properties can be maintained even if the electromagnetic-wave absorbing sheet is strongly bent. For this reason, it is possible to realize an electromagnetic-wave absorbing sheet that exhibits stable high electromagnetic-wave absorbing properties and is flexible and light-transmissive. For example, the electromagnetic-wave absorbing sheet can be suitably used in a situation in which it is required that an interior or exterior is made visible while undesired electromagnetic waves are absorbed and not allowed to pass through, as with a living room curtain put in an electromagnetic-wave shielding state. Furthermore, by setting the surface electric resistance of the electric resistance film to 303 Ω/sq or more and 350 Ω/sq or less, or to 415 Ω/sq or more and 502 Ω/sq or less, it is possible to, at a low cost, obtain electromagnetic-wave absorbing properties in which the reflection attenuation amount is 20 dB or more, which is thought to be sufficient for practical applications, even if the incidence angle range of the electromagnetic waves on the electromagnetic-wave absorbing sheet changes in a range of up to 40 degrees.

Note that more preferably, it was confirmed that by setting the surface electric resistance of the electric resistance film to a range of 310 Ω/sq or more and 345 Ω/sq or less, or to a range of 420 Ω/sq or more to 500 Ω/sq, the reflection attenuation amount of 20 dB or more can be ensured even if the incidence angle α changes in a range of up to 50 degrees. For this reason, by determining whether the electromagnetic-wave incidence angle range that is estimated during actual use is up to 40 degrees or about 50 degrees and forming an electric resistance film having a more suitable surface electric resistance, it is possible to produce an electromagnetic-wave absorbing sheet that can realize electromagnetic-wave absorbing properties that are sufficient in practical applications, over a wide incidence angle range.

Note that in the above-described embodiment, a light-transmissive electromagnetic-wave absorbing sheet was described in which light-transmissive members are used as all of the electric resistance film, the dielectric layer, the electromagnetic-wave shielding layer, and furthermore, when included in the electromagnetic-wave absorbing sheet, the protective layer and adhesive layer, all of which form the electromagnetic-wave absorbing sheet.

However, an electromagnetic-wave absorbing sheet having electromagnetic-wave absorbing properties that are sufficient in practical applications with respect to electromagnetic waves incident in a wide angle range, which is disclosed in the present application, can be realized as an electromagnetic-wave absorbing sheet that is not light-transmissive. In this case, a wider range of materials for implementing the electromagnetic-wave absorbing sheet disclosed in the present application can be selected, such as using a lower-cost material that is not light-transmissive as the materials forming the electric resistance film and the dielectric layer instead of the constituent members of the layers included in the above-described electromagnetic-wave absorbing layers. A low-cost member such as aluminum foil can be employed as the electromagnetic-wave shielding layer as well.

In this manner, according to the electromagnetic-wave absorbing sheet disclosed in the present application, it is possible to exhibit favorable electromagnetic-wave absorbing properties, even if the incidence angles of the electromagnetic waves on the electromagnetic-wave absorbing sheet vary in particular for high-frequency electromagnetic waves in or above a so-called millimeter-wave band.

### Industrial Applicability

The electromagnetic-wave absorbing sheet disclosed in the present application is useful as a flexible electromagnetic-wave absorbing sheet that can stably absorb electromagnetic waves in a high-frequency band in or above a millimeter-wave band, even if the electromagnetic waves are incident in a large incidence angle range.

### List of Reference Numerals

- 1: Electric resistance film
- 2: Dielectric layer
- 3: Electromagnetic-wave shielding layer

## Claims

1. An electromagnetic-wave absorbing sheet formed by stacking an electric resistance film (1), a dielectric layer (2), and an electromagnetic-wave shielding layer (3), the electric resistance film (1) being formed using a conductive organic polymer, and having a surface electric resistance of 303 Ω/sq or more and 350 Ω/sq or less, or 415 Ω/sq or more and 502 Ω/sq or less, and **characterised in that** the dielectric layer (2) is formed using silicone OCA.

2. The electromagnetic-wave absorbing sheet according to claim 1, wherein the electric resistance film (1) has a surface electric resistance of 310 Ω/sq or more and 345 Ω/sq or less, or 420 Ω/sq or more and 500 Ω/sq or less.

3. The electromagnetic-wave absorbing sheet according to claim 1 or 2, wherein the electric resistance film (1), the dielectric layer (2), and the electromagnetic-wave shielding layer (3) are all light-transmissive, and the sheet is light-transmissive overall.

4. The electromagnetic-wave absorbing sheet according to any of claims 1 to 3, wherein the electric resistance film contains poly(3,4-ethylenedioxythiophene), polystyrene sulfonic acid, and polyvinylidene fluoride.

5. The electromagnetic-wave absorbing sheet according to claim 4, wherein the electric resistance film (1) further contains water-soluble polyester.

6. The electromagnetic-wave absorbing sheet according to any of claims 1 to 5, wherein the dielectric layer (2) is set to a layer thickness at which it is possible to absorb electromagnetic waves in a high-frequency band in or above a millimeter-wave band.

## Patentansprüche

1. Elektromagnetische-Wellen-absorbierende Folie, gebildet durch Stapeln eines Elektrischer-Widerstand-Films (1), einer dielektrischen Schicht (2) und einer elektromagnetische Wellen abschirmenden Schicht (3), wobei der Elektrischer-Widerstand-Film (1) unter Verwendung eines leitfähigen organischen Polymers gebildet ist und einen elektrischen Oberflächenwiderstand von 303 Ω/sq oder mehr und 350 Ω/sq oder weniger, oder von 415 Ω/sq oder mehr und 502 Ω/sq oder weniger aufweist,
und **dadurch gekennzeichnet, dass** die dielektrische Schicht (2) unter Verwendung von Silicon-OCA gebildet ist.

2. Elektromagnetische-Wellen-absorbierende Folie gemäß Anspruch 1, wobei der Elektrischer-Widerstand-Film (1) einen elektrischen Oberflächenwiderstand von 310 Ω/sq oder mehr und 345 Ω/sq oder weniger, oder 420 Ω/sq oder mehr und 500 Ω/sq oder weniger aufweist.

3. Elektromagnetische-Wellen-absorbierende Folie gemäß Anspruch 1 oder 2, wobei der Elektrischer-Widerstand-Film (1), die dielektrische Schicht (2) und die elektromagnetische Wellen abschirmende Schicht (3) alle lichtdurchlässig sind und die Folie insgesamt-lichtdurchlässig-ist.

4. Elektromagnetische-Wellen-absorbierende Folie gemäß einem der Ansprüche 1 bis 3, wobei der Elektrischer-Widerstand-Film Poly(3,4-ethylendioxythiophen), Polystyrensulfonsäure und Polyvinylidenfluorid beinhaltet.

5. Elektromagnetische-Wellen-absorbierende Folie gemäß Anspruch 4, wobei der Elektrischer-Widerstand-Film (1) ferner wasserlöslichen-Polyester beinhaltet.

6. Elektromagnetische-Wellen-absorbierende Folie gemäß einem der Ansprüche 1 bis 5, wobei die dielektrische Schicht (2) auf eine Schichtdicke eingestellt ist, bei welcher es ermöglicht ist, elektromagnetische Wellen in einem Hochfrequenzband in oder über einem Millimeterwellenband zu absorbieren.

## Revendications

1. Feuille d'absorption d'onde électromagnétique formée par empilement d'un film de résistance électrique (1), d'une couche diélectrique (2) et d'une couche de blindage contre les ondes électromagnétiques (3), le film de résistance électrique (1) étant formé à l'aide d'un polymère organique conducteur, et ayant une résistance électrique de surface de 303 Ω/carré ou plus et de 350 Ω/carré ou moins, ou de 415 Ω/carré ou plus et de 502 Ω/carré ou moins, et **caractérisée en ce que** la couche diélectrique (2) est formée à l'aide d'OCA de silicone.

2. Feuille d'absorption d'onde électromagnétique selon la revendication 1, dans laquelle le film de résistance électrique (1) a une résistance électrique de surface de 310 Ω/sq ou plus et de 345 Ω/carré ou moins, ou de 420 Ω/sq ou plus et de 500 Ω/carré ou moins.

3. Feuille d'absorption d'onde électromagnétique selon la revendication 1 ou 2, dans laquelle le film de résistance électrique (1), la couche diélectrique (2) et la couche de blindage contre les ondes électromagnétiques (3) transmettent toutes de la lumière, et la feuille transmet globalement de la lumière.

4. Feuille d'absorption d'onde électromagnétique selon l'une quelconque des revendications 1 à 3, dans laquelle le film de résistance électrique contient du poly(3,4-éthylène-dioxythiophène), de l'acide sulfonique de polystyrène et du fluorure de polyvinylidène.

5. Feuille d'absorption d'onde électromagnétique selon la revendication 4, dans laquelle le film de résistance électrique (1) contient en outre du polyester hydrosoluble.

6. Feuille d'absorption d'onde électromagnétique selon l'une quelconque des revendications 1 à 5, dans laquelle la couche diélectrique (2) est réglée à une épaisseur de couche permettant d'absorber des ondes électromagnétiques dans une bande de haute fréquence dans ou au-dessus d'une bande d'ondes millimétriques.
